(19) Europäisches Patentamt
European Patent Office
Office européen des brevets

(11) **EP 3 098 614 B1**

(12) **EUROPEAN PATENT SPECIFICATION**

(45) Date of publication and mention
of the grant of the patent:
**01.07.2020 Bulletin 2020/27**

(51) Int Cl.:
*G01R 31/317* (2006.01)   *H04N 5/235* (2006.01)

(21) Application number: **15305838.3**

(22) Date of filing: **29.05.2015**

(54) **A METHOD AND DEVICE FOR FLICKER MEASUREMENTS PERFORMED ON ELECTRICAL APPLIANCES**

VERFAHREN UND VORRICHTUNG FÜR FLICKERMESSUNGEN AN ELEKTRISCHEN GERÄTEN

PROCÉDÉ ET DISPOSITIF POUR DES MESURES DE SCINTILLEMENT EFFECTUÉES SUR DES APPAREILS ÉLECTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.11.2016 Bulletin 2016/48**

(73) Proprietor: **Electricité de France**
**75008 Paris (FR)**

(72) Inventors:
• **Yang, Xavier**
  **92160 ANTONY (FR)**
• **Niu, Xingyan**
  **Beijing 100005 (CN)**
• **Zhao, Kun**
  **Beijing 100005 (CN)**

(74) Representative: **Plasseraud IP**
**66, rue de la Chaussée d'Antin**
**75440 Paris Cedex 09 (FR)**

(56) References cited:
**US-A- 5 818 208      US-A1- 2008 180 087**
**US-B1- 7 096 133**

• **GALLO D ET AL: "Toward a new flickermeter based on voltage spectral analysis", INDUSTRIAL ELECTRONICS, 2002. ISIE 2002. PROCEEDINGS OF THE 2002 IEEE INTERNATIONAL SYMPOSIUM ON JULY 8-11, 2002, PISCATAWAY, NJ, USA,IEEE, vol. 2, 8 July 2002 (2002-07-08), pages 573-578, XP010598450, ISBN: 978-0-7803-7369-3**
• **CHEN CHENG-I ET AL: "An Accurate Solution Procedure for Calculation of Voltage Flicker Components", IEEE TRANSACTIONS ON INDUSTRIAL ELECTRONICS, IEEE SERVICE CENTER, PISCATAWAY, NJ, USA, vol. 61, no. 5, 1 May 2014 (2014-05-01), pages 2370-2377, XP011530720, ISSN: 0278-0046, DOI: 10.1109/TIE.2013.2270221 [retrieved on 2013-10-18]**

**Description**

The invention relates to the impact of fluctuations in voltage (called "flicker" hereafter) of voltage provided by an electrical network (called "grid" hereafter) on electrical appliances.

The invention is more particularly related to a way to quantify such fluctuations.

In usual known methods, incandescent lamps (bulbs) are used and the flicker of such bulbs, caused by fluctuations in grid voltage, is visible to the naked eye of a user and is a source of inconvenience and maybe of health problems for people exposed therein. A tolerance threshold can be evaluated from experiments. There is no need to quantify the "flicker" according to fluctuations of the grid voltage and/or current, since a human being is able to indicate what level of "flicker" bothers him or not. Therefore, the aforesaid usual methods are based on experiments performed on users so as to determine to which threshold flickers are annoying.

Nowadays, incandescent lamps are less and less used, while LEDs and low energy consumption bulbs tend to replace incandescent lamps and do not generate perceptible flicker.

However, voltage fluctuations remain on the power grid, and current electrical devices are still more sensitive than they were before.

Contrary to a human, it is not possible to request an electrical device to indicate at which point the "flicker" becomes annoying.

The flicker does not "annoy" electrical devices, as it could annoy a human being in particular with an incandescent lamp. But the flicker can reduce the lifetime of electrical appliances and more generally electrical devices.

A retrospective of the known prior art is given hereafter.

Electromagnetic compatibility standards and guidelines used in the determination of compatibility levels and network planning levels of voltage fluctuations at various points of the power system use flicker severity indices as the basis of the procedure.

In order to define an acceptable voltage fluctuation levels, it is sought a method of flicker assessment that models the total response of a lamp, eye and brain to the voltage fluctuations. Numerous studies have been carried out in the past in order to understand how the human vision is influenced by light fluctuations where the relevant model is an important component of a flicker measurement.

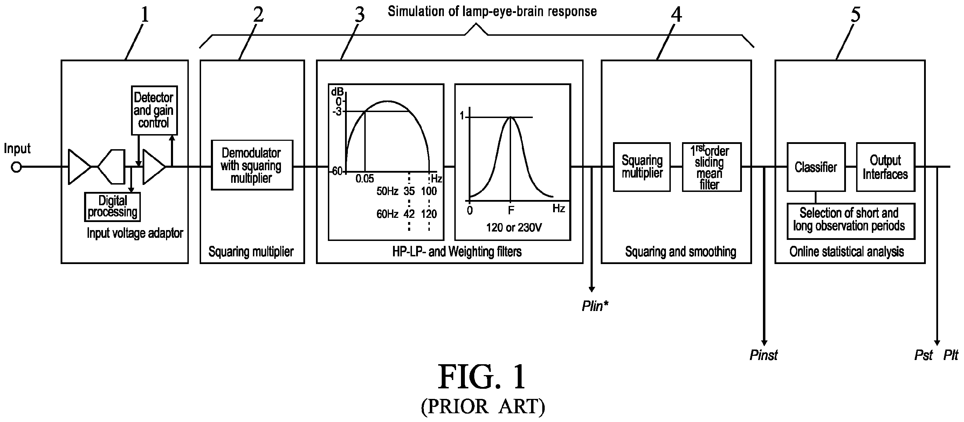

The functional and design specifications of a "flickermeter" can be found in the standard IEC 61000-4-15 as well as the method for flicker severity assessment. The schematic of the flickermeter is illustrated by Figure 1. The main operation can be divided into two terms that consist of:

    (i) simulation of the response of the lamp-eye-brain chain and
    (ii) online statistical analysis of the flicker signal and presentation of results.

Block 1 of Figure 1 corresponds to a input voltage adaptor and calibration checking circuit. There is a voltage adapting circuit that can scale the mean rms value (for "root mean square") of the input fundamental frequency voltage down to an internal reference level such that flicker measurements can be made independently of the actual input carrier voltage level and expressed as a percent ratio.

The voltage input circuit shall accept a wide range of nominal mains voltages and adapt them to the maximum level compatible with the operation of the following circuits in the instrument. The most common rated voltages are listed below. The manufacturer shall specify the voltage(s) for which the instrument is suited. Many nominal supply voltages between 60 V and 690 V exist, depending on local practice. To permit a relatively universal use of the instrument for most supply systems, it is advisable for the input circuit to be designed for the following nominal voltages:
$U$nom: 66 V, 115 V, 230 V, 400 V, 690 V for 50 Hz systems The pass bandwidth of the input stage of the flickermeter shall be indicated by the manufacturer as defined in 6.5, and the pass bandwidth shall be at least 450 Hz.

Block 2 is a quadratic demodulator unit whose purpose is to recover the light fluctuation by squaring the scaled input voltage to the reference level in order to simulate the behavior of an incandescent lamp. Since the incandescent lamp can be considered as a resistive load and the light intensity is strongly dependent on the energy consumed, the light produced by the incandescent lamp is proportional to the square of the input lamp voltage.

Block 3 is composed of a demodulator filter and weighting filter. The demodulator filter consists of a first-order, high-pass filter (3 dB cut-off frequency at 0.05 Hz) to eliminate the DC component caused by the squaring function in block 2 and a low-pass Butterworth filter which is of sixth order with a 3 dB cut-off frequency of 35 Hz for 230 V 50 Hz systems. The combined effect of these filters is to attenuate the DC component and all frequency components higher than the fundamental frequency. The weighting filter simulates the frequency response to fluctuations of a coiled filament gas-filled lamp (60 W, 230 V or 120 V) combined with the characteristics of the human visual system. The response function is based on the perceptibility threshold found at each frequency by 50% of the persons tested.

A suitable transfer function for block 3, assuming that the carrier suppression filter defined above has negligible influence inside the frequency bandwidth associated to voltage fluctuation signals, is of the following type:

$$F(s) = \frac{k\omega_1 s}{s^2 + 2\lambda s + \omega_1^2} \times \frac{1 + s/\omega_2}{(1 + s/\omega_3)(1 + s/\omega_4)}$$

Where "s" is the Laplace complex, and indicative values are given in Table 1 below.

**Table 1**

| Variable | 230 V lamp | 120 V lamp |
|---|---|---|
| K | 1.74802 | 1.6357 |
| A | $2\pi$x4.05981 | $2\pi$x4.167375 |
| $\omega_1$ | $2\pi$x9.15494 | $2\pi$x9.077169 |
| $\omega_2$ | $2\pi$x2.27979 | $2\pi$x2.939902 |
| $\omega_3$ | $2\pi$x1.22535 | $2\pi$x1.394468 |
| $\omega_4$ | $2\pi$x21.9 | $2\pi$x17.31512 |

Block 4 is composed of a squaring multiplier and an integrating function whose purpose is to simulate the storage effect of the human brain. This performance is implemented through a first-order, low-pass filter with a time constant equal to 300 ms (cut-off frequency is 0.53 Hz). The human eye-brain perception can be simulated through the non-linear responses of Blocks 2, 3 and 4. The output of Block 4 is defined as the instantaneous flicker level Pinst. The unit value of Pinst and corresponding voltage amplitude for each specific voltage modulation frequency is defined in IEC 61000-4-15 based on sinusoidal voltage modulation fluctuations and rectangular voltage modulation fluctuations respectively.

Block 5 performs an on-line statistical classification of the instantaneous flicker level, Pinst, and calculates the cumulative probability distribution of the amplitude of the instantaneous flicker sensation. Then, the short-term flicker index, Pst, and long-term flicker index, Pit, can be determined by using statistical methods.

For the short-term flicker evaluation, the measure of severity based on an observation period $T$short = 10 min is designated Pst and is derived from the time-at-level statistics obtained from the level classifier in block 5 of the flickermeter. The following formula is used:

$$P_{st} = \sqrt{0.0314P_{0.1} + 0.0525P_{1s} + 0.0657P_{3s} + 0.28P_{10s} + 0.08P_{50s}}$$

where the percentiles $P_{0.1}$, $P_1$, $P_3$, $P_{10}$, and $P_{50}$ are the flicker levels exceeded for 0.1, 1, 3, 10, and 50% of the time during the observation period. The suffix "s" in the formula indicates that smoothed values should be used; these are obtained using the following equations:

$$P_{50s} = \frac{P_{30} + P_{50} + P_{80}}{3}$$

$$P_{10s} = \frac{P_6 + P_8 + P_{10} + P_{13} + P_{17}}{5}$$

$$P_{3s} = \frac{P_{2.2} + P_3 + P_4}{3}$$

$$P_{50s} = \frac{P_{0.7} + P_1 + P_{1.5}}{3}$$

The long-term flicker severity $P$lt, shall be derived from the short-term severity values Pst, over an appropriate period related to the duty cycle of the load or a period over which an observer may react to flicker, it can be using the following formula:

$$P_{lt} = \sqrt[3]{\frac{\sum_{i=1}^{N} P_{sti}^{2}}{N}}$$

where $P$sti ($i$ = 1, 2, 3, ..., N) are consecutive readings of the short-term severity Pst.

Similar approaches have been proposed in "Toward a New Flickermeter Based on Voltage Spectral Analysis" by Gallo et al. and "An Accurate Solution Procedure for Calculation of Voltage Flicker Components" by Chen-I Chen et al., which rely on a spectral decomposition of an input signal such as a voltage, and which aim at determining a flicker level by aggregating the voltage fluctuation amplitudes provided by the decomposition.

However, such a known flickermeter has been defined by only considering incandescent lamps as reference devices. In fact, these lamps are slowly being replaced by other, high efficiency lamp types in the residential lighting market, such as compact fluorescent lamps (CFLs) and other energy saving lamps. With the new lamp types becoming more popular, the flickermeter standard could be adjusted to other types of lighting by changing the model for the lamp-eye-brain response since different lamp types utilize different technologies and the flicker response of these lamp types can be significantly different.

A significant outcome from recent research is determination that the short term flicker index, Pst, cannot adequately indicate the risk of lifetime reduction for a rectifier DC-link capacitor, for example, nor for an insulation of an induction motor. Presently, Pst is the only indicator for used voltage fluctuation disturbances in determining power system electromagnetic compatibility levels and planning levels in addition to limits on rapid voltage change limits specified in some standards. Thus, the use of only Pst to assess voltage fluctuation level is not appropriate. A comprehensive index or method should be proposed to alleviate the limitations of Pst and be used to assess the voltage fluctuations effects on other sensitive equipment.

The proposed method can be used to estimate the effect on any electrical equipment caused by flicker problems, not only for traditional incandescent lamps. The traditional incandescent flickermeter only concerns the effect on human eyes except any other sensitive electrical equipment.

The present invention aims to improve the situation.

To that end, the invention provides a method of characterization of an influence, on at least one electrical device, of voltage fluctuations in power provided by an electrical network to said electrical device powered by said electrical network. More particularly, the method comprises at least the steps of:

- applying a short-time Fourier transform to an input signal representing voltage provided to the electrical device by the electrical network, so as to determine at least both a frequency and a magnitude of said fluctuations,
- calculating a cumulative effect of said frequency and magnitude, and
- comparing said effect to a threshold so as to evaluate a risk of damaging said electrical device.

In an embodiment, for calculating said cumulative effect, a voltage fluctuation index for said electrical device is calculated by using an equation of the following type:

$$P_{vfe} = \sum_{i=1}^{M} \sum_{j=1}^{N} A_{i,j} \cdot T_{i,j} \cdot V_{ci} \cdot F_{cj}$$

where:

$P_{vfe}$ is a voltage fluctuation index calculated for said electrical device,
$A_{i,j}$ are weighting coefficients for different voltage change rates and modulation frequency,
$V_{ci}$ is a voltage change rate,
$F_{cj}$ is a voltage change frequency, and
$T_{i,j}$ is a voltage fluctuation duration time.

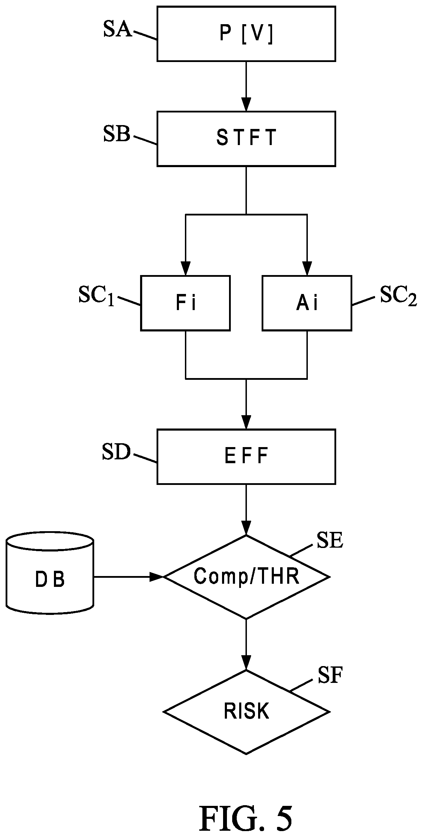

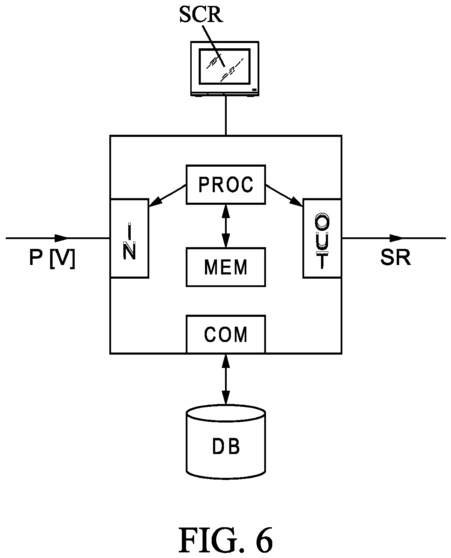

For example, the aforesaid weighting coefficients $A_{i,j}$ can be previously obtained through statistical experiments performed on electrical devices of a same type as said electrical device, and can be stored in a memory (such as a memory of a database DB as shown in figures 5 and 6 commented below), as a table of N columns and M rows.

In an exemplary embodiment, the short-time Fourier transform can be calculated on a time window of several seconds, for example 10 seconds.

Advantageously, the method can further comprise a step of attenuating at least a DC component of the input signal before applying the short-time Fourier transform.

In an embodiment, the method further comprises an envelope detection in the input signal before applying the short-time Fourier transform.

In an embodiment, a low-pass filter can further be applied to the input signal prior to the short-time Fourier transform application.

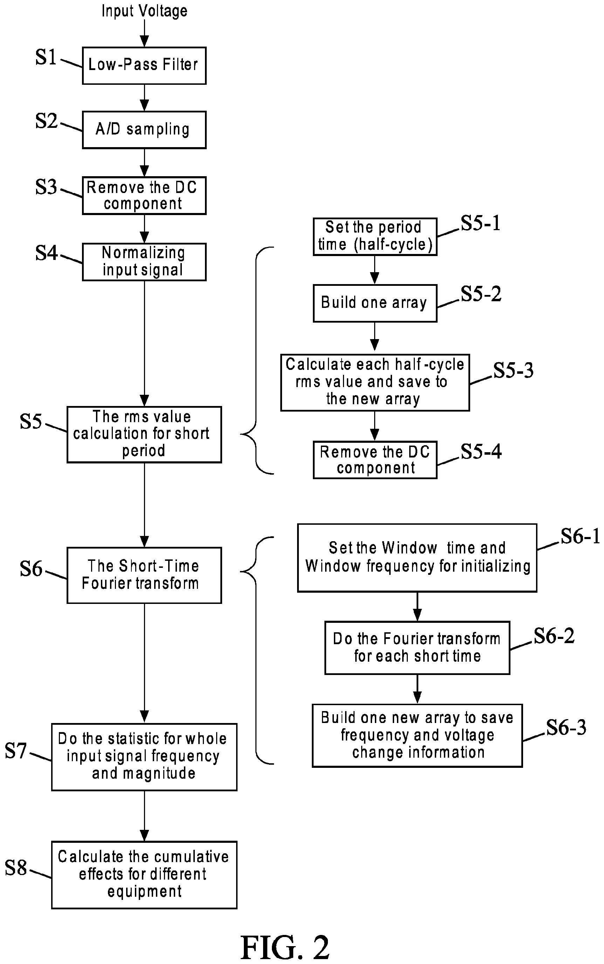

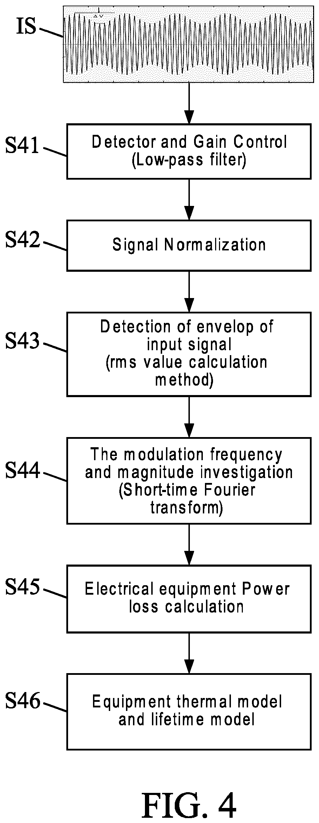

The invention aims also at a computer program product, comprising instructions for performing the method of the invention, when run by a processor. As for an example, figure 5 (and also figures 2 and 4) can represent a general algorithm of the computer program.

The invention aims also at a device for characterizing an influence, on at least one electrical equipment, of voltage fluctuations in power provided by an electrical network to that electrical equipment. Typically, the device of the invention (as shown on figure 6 commented below) can comprise at least:

- an input interface to receive an input signal representing voltage provided by the electrical network to the electrical equipment,
- a processing unit:

  * applying a short-time Fourier transform to said input signal, so as to determine at least both a frequency and a magnitude of said fluctuations,
  * calculating a cumulative effect of said frequency and magnitude, and
  * comparing said effect to a threshold so as to evaluate a risk of damaging said electrical equipment,

- an output interface so as to deliver an output signal related to said risk.

Therefore, according to an advantage of the invention, it is possible to carry out a quantization of "flicker", depending on both the frequency and the amplitude of the voltage. In fact, one of the main difficulties that the invention overcomes comes from the fact that the "flicker" depends on these two parameters (frequency and amplitude).

The proposed method can thus realize a specific function dedicated to any equipment different from incandescent light since the flickermeter of the prior art cannot indicate the electrical equipment risk caused by voltage fluctuations, especially the low frequency range.

The method of the invention, based on related research, outcomes and proposes some specific filters and frequency analysis method, such as a Short-Time Fourier Transform (STFT) method and statistic method to develop a new power quality index, in order to indicate the equipment lifetime risk reduction.

The present invention is illustrated by way of example, and not by way of limitation, in the figures of the accompanying drawings, in which like reference numerals refer to similar elements and in which:

- Figure 1 shows schematically a processing device for flicker measurement according to the prior art ;

- Figure 2 shows schematically steps of a method according to an embodiment of the invention for flicker measurement;

- Figure 3 shows, as for a comparison, the main steps of a method according to the prior art, based on flicker perception on an incandescent lamp,

- Figure 4 shows main steps of a method according to the invention, for a comparison with the method of figure 3,

- Figure 5 shows the main steps of the method according to an embodiment of the invention, and can thus correspond to a main algorithm of a computer program according to the invention,

- Figure 6 shows schematically a device for performing the method of the invention.

The proposed flickermeter according to an embodiment of the invention, is shown in Figure 2. In step S1, a low-pass filter is applied with a cut-off frequency of low-pass filter at 200 Hz in order to filter high frequency signal interfering. In step S2, an analogic/digital sampling is performed with a sampling rate preferably higher than 1 M/s at least. In step S3, a DC component of the signals is removed in order to avoid calculating error.

Therefore, a requirement which is fulfilled here is that the input voltage signal is line-to-natural voltage after the voltage transducer.

In step S4, the input signal is normalized using its maximum value as basement, for simplification purpose.

Step S5 aims at the rms value calculation for short period, with the following sub-steps:

- At sub-step S5-1, the period time is set to 10 ms (for the electrical network frequency: 50Hz), so as to actually calculate the rms value of each half-cycle for the whole signals,
- At sub-step S5-2, one new array is built to store the rms value,
- At sub-step S5-3, a loop calculation is made in order to calculate each half-cycle rms value and rebuild one new signal,
- At sub-step S5-4, the DC component is removed again for the new data.

Step S6 corresponds to the application of a Short-Time Fourier Transform (STFT) to the new data. More particularly, for operating Fourier transform, in sub-step S6-1, the window time is selected preferably as 10 seconds. This window time determines the frequency accuracy. Therefore, for different accuracy demand, the windows time selection needs to be controlled carefully. In sub-step S6-2, the Fourier transform is operated for each short time. In sub-step S6-3, a new array (as shown in table 1) is built to store the Short-Time Fourier Transform results. The array information includes modulation frequency and response magnitude (i.e. voltage amplitude, or possibly current amplitude).

In step S7, statistics are performed for all input signal frequency and magnitude. The calculations are performed with the results of Short-Time Fourier transform for the whole time period. The array is preferably $10\times35$ (see table 1 below). Each row of the array corresponds to a voltage change rate while each column corresponds to a modulation frequency of voltage fluctuations (for a pure sinusoidal waveform, the results are zero).

In step S8, for different electrical equipments, the cumulative thermal impacts and related lifetime reduction is then estimated from voltage fluctuation perspective (and not only for the usual light flicker term).

The new voltage fluctuation index (Pvfe) for equipment estimation can be calculated by using the following equation:

$$ P_{vfe} = \sum_{i=1}^{25} \sum_{j=1}^{10} A_{i,j} \cdot T_{i,j} \cdot V_{ci} \cdot F_{cj} $$

where,

$P_{vfe}$ is the new voltage fluctuation index for an equipment,
$A_{i,j}$ is a weighting coefficient for different voltage change rates and modulation frequency (each weighting coefficient can be measured),
$V_{ci}$ is a voltage change rate,
$F_{cj}$ is a modulation frequency, and
$T_{i,j}$ is the voltage fluctuation duration time. Fluctuation over the power grid may last from few minutes to hours. Here, in a practical embodiment, two indexes are used with two respective values: ten minutes and two hours.

For different electrical equipment, the values of coefficients $A_{i,j}$ need to be obtained through series of experiments and/or through industry investigation with manufacturers.

The $A_{i,j}$ coefficients can be defined from the following table:

|  | 1% | 2% | 3% | 4% | 5% | 6% | 7% | 8% | 9% | 10% |
|---|---|---|---|---|---|---|---|---|---|---|
| 1Hz | $A_{1,1}$ | $A_{1,2}$ | $A_{1,3}$ | $A_{1,4}$ | $A_{1,5}$ | $A_{1,6}$ | $A_{1,7}$ | $A_{1,8}$ | $A_{1,9}$ | $A_{1,10}$ |
| 2 Hz | $A_{2,1}$ | $A_{2,2}$ | $A_{2,3}$ | $A_{2,4}$ | $A_{2,5}$ | $A_{2,6}$ | $A_{2,7}$ | $A_{2,8}$ | $A_{2,9}$ | $A_{2,10}$ |
| 3 Hz | $A_{3,1}$ | $A_{3,2}$ | $A_{3,3}$ | $A_{3,4}$ | $A_{3,5}$ | $A_{3,6}$ | $A_{3,7}$ | $A_{3,8}$ | $A_{3,9}$ | $A_{3,10}$ |
| 4 Hz | $A_{4,1}$ | $A_{4,2}$ | $A_{4,3}$ | $A_{4,4}$ | $A_{4,5}$ | $A_{4,6}$ | $A_{4,7}$ | $A_{4,8}$ | $A_{4,9}$ | $A_{4,10}$ |
| 5 Hz | $A_{5,1}$ | $A_{5,2}$ | $A_{5,3}$ | $A_{5,4}$ | $A_{5,5}$ | $A_{5,6}$ | $A_{5,7}$ | $A_{5,8}$ | $A_{5,9}$ | $A_{5,10}$ |
| 6 Hz | $A_{6,1}$ | $A_{6,2}$ | $A_{6,3}$ | $A_{6,4}$ | $A_{6,5}$ | $A_{6,6}$ | $A_{6,7}$ | $A_{6,8}$ | $A_{6,9}$ | $A_{6,10}$ |
| 7 Hz | $A_{7,1}$ | $A_{7,2}$ | $A_{7,3}$ | $A_{7,4}$ | $A_{7,5}$ | $A_{7,6}$ | $A_{7,7}$ | $A_{7,8}$ | $A_{7,9}$ | $A_{7,10}$ |

(continued)

| | | | | | | | | | | |
|---|---|---|---|---|---|---|---|---|---|---|
| 8 Hz | $A_{8,1}$ | $A_{8,2}$ | $A_{8,3}$ | $A_{8,4}$ | $A_{8,5}$ | $A_{8,6}$ | $A_{8,7}$ | $A_{8,8}$ | $A_{8,9}$ | $A_{8,10}$ |
| 9 Hz | $A_{9,1}$ | $A_{9,2}$ | $A_{9,3}$ | $A_{9,4}$ | $A_{9,5}$ | $A_{9,6}$ | $A_{9,7}$ | $A_{9,8}$ | $A_{9,9}$ | $A_{9,10}$ |
| 10 Hz | $A_{10,1}$ | $A_{10,2}$ | $A_{10,3}$ | $A_{10,4}$ | $A_{10,5}$ | $A_{10,6}$ | $A_{10,7}$ | $A_{10,8}$ | $A_{10,9}$ | $A_{10,10}$ |
| 11 Hz | $A_{11,1}$ | $A_{11,2}$ | $A_{11,3}$ | $A_{11,4}$ | $A_{11,5}$ | $A_{11,6}$ | $A_{11,7}$ | $A_{11,8}$ | $A_{11,9}$ | $A_{11,10}$ |
| 12 Hz | $A_{12,1}$ | $A_{12,2}$ | $A_{12,3}$ | $A_{12,4}$ | $A_{12,5}$ | $A_{12,6}$ | $A_{12,7}$ | $A_{12,8}$ | $A_{12,9}$ | $A_{12,10}$ |
| 13 Hz | $A_{13,1}$ | $A_{13,2}$ | $A_{13,3}$ | $A_{13,4}$ | $A_{13,5}$ | $A_{13,6}$ | $A_{13,7}$ | $A_{13,8}$ | $A_{13,9}$ | $A_{13,10}$ |
| 14 Hz | $A_{14,1}$ | $A_{14,2}$ | $A_{14,3}$ | $A_{14,4}$ | $A_{14,5}$ | $A_{14,6}$ | $A_{14,7}$ | $A_{14,8}$ | $A_{14,9}$ | $A_{14,10}$ |
| 15 Hz | $A_{15,1}$ | $A_{15,2}$ | $A_{15,3}$ | $A_{15,4}$ | $A_{15,5}$ | $A_{15,6}$ | $A_{15,7}$ | $A_{15,8}$ | $A_{15,9}$ | $A_{15,10}$ |
| 16 Hz | $A_{16,1}$ | $A_{16,2}$ | $A_{16,3}$ | $A_{16,4}$ | $A_{16,5}$ | $A_{16,6}$ | $A_{16,7}$ | $A_{16,8}$ | $A_{16,9}$ | $A_{16,10}$ |
| 17 Hz | $A_{17,1}$ | $A_{17,2}$ | $A_{17,3}$ | $A_{17,4}$ | $A_{17,5}$ | $A_{17,6}$ | $A_{17,7}$ | $A_{17,8}$ | $A_{17,9}$ | $A_{17,10}$ |
| 18 Hz | $A_{18,1}$ | $A_{18,2}$ | $A_{18,3}$ | $A_{18,4}$ | $A_{18,5}$ | $A_{18,6}$ | $A_{18,7}$ | $A_{18,8}$ | $A_{18,9}$ | $A_{18,10}$ |
| 19 Hz | $A_{19,1}$ | $A_{19,2}$ | $A_{19,3}$ | $A_{19,4}$ | $A_{19,5}$ | $A_{19,6}$ | $A_{19,7}$ | $A_{19,8}$ | $A_{19,9}$ | $A_{19,10}$ |
| 20 Hz | $A_{20,1}$ | $A_{20,2}$ | $A_{20,3}$ | $A_{20,4}$ | $A_{20,5}$ | $A_{20,6}$ | $A_{20,7}$ | $A_{20,8}$ | $A_{20,9}$ | $A_{20,10}$ |
| 21 Hz | $A_{21,1}$ | $A_{21,2}$ | $A_{21,3}$ | $A_{21,4}$ | $A_{21,5}$ | $A_{21,6}$ | $A_{21,7}$ | $A_{21,8}$ | $A_{21,9}$ | $A_{21,10}$ |
| 22 Hz | $A_{22,1}$ | $A_{22,2}$ | $A_{22,3}$ | $A_{22,4}$ | $A_{22,5}$ | $A_{22,6}$ | $A_{22,7}$ | $A_{22,8}$ | $A_{22,9}$ | $A_{22,10}$ |
| 23 Hz | $A_{23,1}$ | $A_{23,2}$ | $A_{23,3}$ | $A_{23,4}$ | $A_{23,5}$ | $A_{23,6}$ | $A_{23,7}$ | $A_{23,8}$ | $A_{23,9}$ | $A_{23,10}$ |
| 24 Hz | $A_{24,1}$ | $A_{24,2}$ | $A_{24,3}$ | $A_{24,4}$ | $A_{24,5}$ | $A_{24,6}$ | $A_{24,7}$ | $A_{24,8}$ | $A_{24,9}$ | $A_{2410}$ |
| 25 Hz | $A_{25,1}$ | $A_{25,2}$ | $A_{25,3}$ | $A_{25,4}$ | $A_{25,5}$ | $A_{25,6}$ | $A_{25,7}$ | $A_{25,8}$ | $A_{25,9}$ | $A_{25,10}$ |

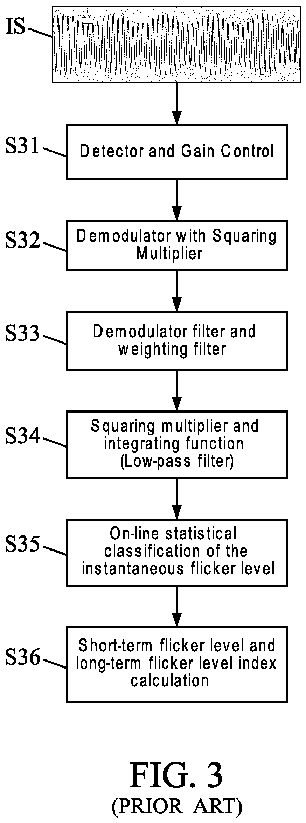

The traditional flickermeter structure work principle (only for incandescent lamp estimation) is shown on figure 3, for comparison with the proposed flickermeter structure principle according to the invention (for different equipment lifetime estimation) shown on figure 4.

Referring now to figure 3, the first step S31 is performed so as to scale the mean rms value of the input signal. To that end, a detection and gain control is performed on the input signal is. Then, in step S32, a demodulation with squaring multiplication is applied so as to simulate the behavior of an incandescent lamp. In next step S33, a demodulator filter is applied with a weighting filter, so as to attenuate the DC component and all frequency components higher than the fundamental frequency and meanwhile to simulate a human visual system. In next step S34, a squaring multiplication and integrating function are performed with a low pass filter so as to simulate the storage effect of the human brain. In next step S35, online statistical classification of the instantaneous flicker level is performed. Then, in step S36, short-time flicker level and long-term flicker level indexes are calculated. This provides a helpful flicker measuring for incandescent lamps, in particular.

However, the steps of figure 3 are not compatible with the damage characterization which can be caused to electronic devices, due to possible random voltage variation.

Referring now to figure 4 showing, as an exemplary embodiment, main steps of the method according to the invention, the first step S41 corresponds to a detection and gain control using preferably a low-pass filter so as to process and scale initial data (input signal is). The next step S42 corresponds to a signal normalization so as to transfer different voltage levels into a same scaled signal. Next step S43 corresponds to the detection of the envelope of the input signal (rms value calculation) so as to attenuate the DC component and detect the modulation frequency components. Next step S44 corresponds to the modulation frequency and magnitude investigation (with a short-time Fourier transform) so as to analyze the modulation frequency and the response magnitude for the whole signal. Step S45 corresponds to the electrical equipment power loss calculation and step S46 corresponds to the equipment thermal model and finally lifetime model so as to estimate a lifetime reduction caused by flicker.

Therefore, the traditional flickermeter (implementing the steps of figure 3) only assesses the light flicker impact on human visual, which is caused by the incandescent lamps. The proposed flickermeter (implementing the steps of figure 4) can be used to detect the modulation frequency and voltage change rates, which can cause electrical equipment lifetime reduction. However, the thermal issue or lifetime estimation of electrical equipments health status cannot be measured by using a traditional flickermeter. The proposed structure of flickermeter can thus improve the function of current flickermeters.

Of course, the present invention is not limited to the description provided above as an example of embodiment; it encompasses possible variants.

As mentioned before, for the proposed flickermeter structure, the purpose of steps S1, S2, S3, S4 is to rescale the input voltage signals. The A/D sampling in step S2 can be arranged and combined with the first step S1, and then change the Low-Pass filter to a digital filter. For example, the cut-off frequency in step S1 can be selected from case to case. Normally, there are many methods for removing DC components and normalizing signal. The method selection and parameters determination can be adapted to any real case situation.

Step S5 is to detect the envelop waveform of input signal. The aim of this block is to extract the modulation frequency and voltage change rates. The rms value calculation is an example of a method that can extract the envelop waveform. As a variant, for example, the "maximum value detection" method can also rebuild the envelop waveform. Thus, the method that can rebuild the envelop waveform can be also adopted and replace the rms value calculation method.

Step S6 is to analyze the envelop waveform frequency, which means the modulation frequency of the flicker. The detail of Fourier transform can be different, such as the windows width selection, the frequency accuracy and the step length of windows shift, etc.

Step S7 and step S8 can be modified according to different estimated objects. For example, the estimation parameter selection may be totally different for a capacitor or an induction motor. Therefore, the cumulative effect on sensitive equipments can be adapted from case to case.

The main steps of the method according to an embodiment of the invention have been summarized on figure 5. In a first step SA, a parameter related to the voltage as provided by the power grid is measured over the time and, in step SB, a short-time Fourier transform (STFT transform) is applied to that parameter. In steps SC1 and SC2, the application of that STFT transform gives at least one frequency Fi and magnitude Ai of fluctuations of voltage provided by the power grid. Then, in next step SD, a cumulative effect EFF of the frequency and magnitude can be calculated (with a formula such as for example the one giving the voltage fluctuation index

$$P_{vfe} = \sum_{i=1}^{25} \sum_{j=1}^{10} A_{i,j} \cdot T_{i,j} \cdot V_{ci} \cdot F_{cj}).$$

In step SE, when considering a device susceptible to get damaged owing to severe voltage fluctuations, it can be referred to a database DB giving a threshold value THR corresponding to a resistance to voltage fluctuations for that kind of device, so as to compare the calculated cumulative effect EFF to that threshold value THR. In step SF, if the effect EFF is higher than the threshold THR (meaning that there is a real risk to damage the device), then, an alarm can be triggered (meaning that the flicker level may exceed the tolerance of the device).

For example, if the device is an element of the power grid network which can be sensitive to voltage fluctuations, then, a user having that information on a monitoring computer screen SCR (figure 6) can decide to send an alarm or even switch off that element (if there is no real consequence on the distribution grid).

With reference now to figure 6, the device according to the invention comprises an input interface IN, so as to receive a parameter P [V] representing the voltage provided by the power grid, over the time. The device further comprises:

- a processing unit PROC (a processor, or an FPGA, or a DSP, etc.),
- a memory unit MEM, which stores:

  ∘ the initial values and intermediate results of the respective method steps and
  ∘ instructions for the processing unit PROC in form of a computer program, and

- an output interface OUT, which outputs comparison results and/or an alarm signal SR when needed,
- a communication interface to send requests to database DB and receive results such as device threshold values THR.

The memory unit MEM may be divided into a working memory, which stores initial values, intermediate results and/or output values, and a memory such as a non-transitory computer storage medium for storing the instructions for the processing unit PROC in form of a computer program.

The device may further include an interface with a screen SCR so as to display comparison results (between the effect EFF and the threshold THR) as well as alarm information (when needed).

In an alternative embodiment, the device according to the invention may be implemented as a module which is integrated in a device to be monitored and being susceptible to suffer from voltage fluctuations. For example, the output OUT of that module can deliver a signal SR which can inform or even interrupt the operation of the device hosting the module (typically for powering off the device), when the fluctuations effect EFF is higher than the resistance threshold of the device. Typically, a screen (or a LED having a particular color) provided in the device can inform a user that he should wait for voltage fluctuations to last before using again his device. In that case, there is no need to refer to a database DB since the threshold value (usually provided by the manufacturer) can be stored already in memory MEM.

Of course, the present invention is not limited to the description provided above as an example of embodiment; it encompasses possible variants and is only limited by the attached claims. Typically, it has been disclosed above a method directly based on voltage to estimate voltage fluctuations. However, the invention may use alternatively any other parameter related to voltage to that end.

**Claims**

1. A method of characterization of an influence of voltage fluctuations on an electrical device powered by an electrical network,
   wherein said method comprises at least the steps of:

   - applying a short-time Fourier transform to an input signal representing voltage provided by the electrical network to the electrical device, so as to determine at least both a frequency and a magnitude of said fluctuations,
   - calculating a cumulative effect of said frequency and magnitude, and
   - comparing said effect to a threshold so as to evaluate a risk of damaging said electrical device.

2. The method of claim 1, wherein, for calculating said cumulative effect, a voltage fluctuation index for said electrical device is calculated by using an equation of the following type:

$$P_{vfe} = \sum_{i=1}^{M} \sum_{j=1}^{N} A_{i,j} \cdot T_{i,j} \cdot V_{ci} \cdot F_{cj}$$

   where:

   $P_{vfe}$ is a voltage fluctuation index calculated for said electrical device, $A_{i,j}$ are weighting coefficients for different voltage change rates and
   modulation frequency,
   $V_{ci}$ is a voltage change rate,
   $F_{cj}$ is a voltage change frequency, and
   $T_{i,j}$ is a voltage fluctuation duration time.

3. The method of claim 2, wherein said weighting coefficients $A_{i,j}$ are previously obtained through statistical experiments performed on electrical devices of a same type as said electrical device, and are stored in a memory as a table of N columns and M rows.

4. The method according to any of claims 1 to 3, wherein said short-time Fourier transform is calculated on a time window of 10 seconds.

5. The method according to any of claims 1 to 4, further comprising a step of attenuating at least a DC component of said input signal before applying said short-time Fourier transform.

6. The method according to any of claims 1 to 5, comprising an envelope detection in said input signal before applying said short-time Fourier transform.

7. The method according to any of claims 1 to 6, wherein a low-pass filter is applied to the input signal prior to the short-time Fourier transform application.

8. A computer program product, comprising instructions for performing the method as claimed in any of the preceding claims, when run by a processor.

9. A device for characterizing an influence of voltage fluctuations on an electrical equipment powered by an electrical network,
   wherein said device comprises at least:

   - an input interface (IN) to receive an input signal (P [V]) representing voltage provided by the electrical network to the electrical equipment,
- a processing unit (PROC):

    * applying a short-time Fourier transform to said input signal, so as to determine at least both a frequency and a magnitude of said fluctuations,
    * calculating a cumulative effect of said frequency and magnitude, and
    * comparing said effect to a threshold so as to evaluate a risk of damaging said electrical equipment,

- an output interface (OUT) so as to deliver an output signal (SR) related to said risk.

**Patentansprüche**

1. Verfahren zur Charakterisierung des Einflusses von Spannungsschwankungen auf ein durch ein Stromnetz betriebenes elektrisches Gerät,
wobei das Verfahren mindestens die folgenden Schritte aufweist:

    - Anwenden einer Kurzzeit-Fourier-Transformation auf ein Eingangssignal, das die durch das Stromnetz dem elektrischen Gerät zugeführte Spannung repräsentiert, um wenigstens sowohl die Frequenz als auch die Größe der Schwankungen zu ermitteln,
    - Berechnen einer kumulativen Wirkung der Frequenz und der Größe, und
    - Vergleichen der Wirkung mit einem Schwellwert, um die Gefahr der Beschädigung des elektrischen Geräts zu bewerten.

2. Verfahren nach Anspruch 1, wobei zur Berechnung der kumulativen Wirkung ein Spannungsschwankungsindex für das elektrische Gerät mit Hilfe einer Gleichung des folgenden Typs berechnet wird:

$$P_{vfe} = \sum_{i=1}^{M} \sum_{j=1}^{N} A_{i,j} \cdot T_{i,j} \cdot V_{ci} \cdot F_{cj}$$

wobei:

    $P_{vfe}$ ein für das elektrische Gerät berechneter Spannungsschwankungsindex ist, $A_{i,j}$ Gewichtungskoeffizienten für verschiedene Spannungsänderungsraten und die Modulationsfrequenz sind,
    $V_{ci}$ eine Spannungsänderungsrate darstellt,
    $F_{cj}$ eine Spannungsänderungsfrequenz darstellt, und
    $T_{i,j}$ die Zeitdauer einer Spannungsschwankung darstellt.

3. Verfahren nach Anspruch 2, wobei die Gewichtungskoeffizienten $A_{i,j}$ zuvor durch statistische Experimente ermittelt werden, die an elektrischen Geräten vom selben Typ wie das genannte elektrische Gerät durchgeführt werden, und in Form einer Tabelle mit N Spalten und M Reihen in einem Speicher gespeichert werden.

4. Verfahren nach einem der Ansprüche 1 bis 3, wobei die Kurzzeit-Fourier-Transformation auf einem Zeitfenster von 10 Sekunden berechnet wird.

5. Verfahren nach einem der Ansprüche 1 bis 4, ferner aufweisend einen Schritt der Dämpfung mindestens einer Gleichstromkomponente des Eingangssignals vor Anwendung der Kurzzeit-Fourier-Transformation.

6. Verfahren nach einem der Ansprüche 1 bis 5, aufweisend eine Hüllkurvenerfassung bei dem Eingangssignal vor der Anwendung der Kurzzeit-Fourier-Transformation.

7. Verfahren nach einem der Ansprüche 1 bis 6, wobei vor der Kurzzeit-Fourier-Transformation ein Tiefpassfilter bei dem Eingangssignal angewandt wird.

8. Computerprogramm-Produkt, aufweisend Befehle zum Durchführen des Verfahrens nach einem der vorhergehenden Ansprüche, wenn dieses von einem Prozessor ausgeführt wird.

9. Vorrichtung zur Charakterisierung des Einflusses von Spannungsschwankungen auf ein über ein Stromnetz betriebenes elektrisches Gerät, wobei die Vorrichtung mindestens Folgendes aufweist:

- eine Eingangsschnittstelle (IN) zum Empfang eines Eingangssignals (P[V]), das eine durch das Stromnetz dem elektrischen Gerät zugeführte Spannung repräsentiert,
- eine Verarbeitungseinheit (PROC), die:

* eine Kurzzeit-Fourier-Transformation auf das Eingangssignal anwendet, um wenigstens sowohl eine Frequenz als auch eine Größe der Schwankungen zu ermitteln,
* eine kumulative Wirkung der Frequenz und der Größe berechnet, und
* die Wirkung mit einem Schwellwert vergleicht, um die Gefahr einer Beschädigung des elektrischen Geräts zu bewerten,

- eine Ausgangsschnittstelle (OUT), die ein die besagte Gefahr betreffendes Ausgangssignal (SR) liefert.

## Revendications

1. Procédé de caractérisation d'une influence de fluctuations de tension sur un dispositif électrique alimenté par un réseau électrique,
dans lequel ledit procédé comprend au moins les étapes :

- d'application d'une transformée de Fourier à court terme à un signal d'entrée représentant la tension fournie par le réseau électrique au dispositif électrique, de façon à déterminer au moins à la fois une fréquence et une amplitude desdites fluctuations,
- de calcul d'un effet cumulé desdites fréquence et amplitude, et
- de comparaison dudit effet à un seuil de façon à évaluer un risque d'endommagement dudit dispositif électrique.

2. Procédé selon la revendication 1, dans lequel, pour calculer ledit effet cumulé, un indice de fluctuation de tension pour ledit dispositif électrique est calculé en utilisant une équation du type suivant :

$$P_{vfe} = \sum_{i=1}^{M} \sum_{j=1}^{N} A_{i,j} \cdot T_{i,j} \cdot V_{ci} \cdot F_{cj}$$

où :

$P_{vfe}$ est un indice de fluctuation de tension calculé pour ledit dispositif électrique,
$A_{i,j}$ sont des coefficients de pondération pour différents taux de changement de tension et une fréquence de modulation,
$V_{ci}$ est un taux de changement de tension,
$F_{cj}$ est une fréquence de changement de tension, et
$T_{i,j}$ est une durée de fluctuation de tension.

3. Procédé selon la revendication 2, dans lequel lesdits coefficients de pondération $A_{i,j}$ sont obtenus au préalable par des expériences statistiques réalisées sur des dispositifs électriques d'un même type que ledit dispositif électrique, et sont stockés dans une mémoire sous la forme d'un tableau de N colonnes et M lignes.

4. Procédé selon l'une quelconque des revendications 1 à 3, dans lequel ladite transformée de Fourier à court terme est calculée sur une fenêtre de temps de 10 secondes.

5. Procédé selon l'une quelconque des revendications 1 à 4, comprenant en outre une étape d'atténuation d'au moins un composant CC dudit signal d'entrée avant d'appliquer ladite transformée de Fourier à court terme.

6. Procédé selon l'une quelconque des revendications 1 à 5, comprenant une détection d'enveloppe dans ledit signal d'entrée avant d'appliquer ladite transformée de Fourier à court terme.

7. Procédé selon l'une quelconque des revendications 1 à 6, dans lequel un filtre passe-bas est appliqué au signal d'entrée avant l'application de la transformée de Fourier à court terme.

8. Produit de programme informatique, comprenant des instructions pour mettre en œuvre le procédé selon l'une quelconque des revendications précédentes, lorsqu'il est exécuté par un processeur.

9. Dispositif pour caractériser une influence des fluctuations de tension sur un équipement électrique alimenté par un réseau électrique,
   dans lequel ledit dispositif comprend au moins :

   - une interface d'entrée (IN) pour recevoir un signal d'entrée (P [V]) représentant la tension fournie par le réseau électrique à l'équipement électrique,
   - une unité de traitement (PROC) :

     * appliquant une transformée de Fourier à court terme audit signal d'entrée, de façon à déterminer au moins à la fois une fréquence et une amplitude desdites fluctuations,
     * calculant un effet cumulé desdites fréquence et amplitude, et
     * comparant ledit effet à un seuil de façon à évaluer un risque d'endommagement dudit dispositif électrique,

   - une interface de sortie (OUT) de façon à délivrer un signal de sortie (SR) lié audit risque.

FIG. 1

(PRIOR ART)

EP 3 098 614 B1

Input Voltage

S1 — Low-Pass Filter

S2 — A/D sampling

S3 — Remove the DC component

S4 — Normalizing input signal

S5 — The rms value calculation for short period

S5-1 — Set the period time (half-cycle)

S5-2 — Build one array

S5-3 — Calculate each half-cycle rms value and save to the new array

S5-4 — Remove the DC component

S6 — The Short-Time Fourier transform

S6-1 — Set the Window time and Window frequency for initializing

S6-2 — Do the Fourier transform for each short time

S6-3 — Build one new array to save frequency and voltage change information

S7 — Do the statistic for whole input signal frequency and magnitude

S8 — Calculate the cumulative effects for different equipment

FIG. 2

IS

S31 — Detector and Gain Control

S32 — Demodulator with Squaring Multiplier

S33 — Demodulator filter and weighting filter

S34 — Squaring multiplier and integrating function (Low-pass filter)

S35 — On-line statistical classification of the instantaneous flicker level

S36 — Short-term flicker level and long-term flicker level index calculation

# FIG. 3
(PRIOR ART)

IS

S41 — Detector and Gain Control
(Low-pass filter)

S42 — Signal Normalization

S43 — Detection of envelop of
input signal
(rms value calculation
method)

S44 — The modulation frequency
and magnitude investigation
(Short-time Fourier
transform)

S45 — Electrical equipment Power
loss calculation

S46 — Equipment thermal model
and lifetime model

# FIG. 4

SA — P [V]

SB — S T F T

SC$_1$ — F i        A i — SC$_2$

SD — E F F

DB → Comp/THR — SE

RISK — SF

# FIG. 5

FIG. 6

**EP 3 098 614 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **GALLO.** *Toward a New Flickermeter Based on Voltage Spectral Analysis*

- **CHEN-I CHEN.** *An Accurate Solution Procedure for Calculation of Voltage Flicker Components*